# FASCICULE DE BREVET EUROPEEN

(11) **EP 3 735 729 B1**
(45) Date de publication et mention de la délivrance du brevet: **08.11.2023**
(21) Numéro de dépôt: 19703391.3
(22) Date de dépôt: 03.01.2019
(51) Int. Cl.: H02J 7/00, G01R 31/396, G01R 31/3832

(54) **BATTERIE A ACCUMULATEURS COMMUTES**
BATTERIE MIT GESCHALTETEN AKKUMULATOREN
BATTERY WITH SWITCHED ACCUMULATORS

(30) Priorité: 05.01.2018 FR 1850067
(43) Date de publication de la demande: 11.11.2020
(73) Titulaire: Commissariat à l'Energie Atomique et aux Energies Alternatives, 75015 Paris (FR)
(72) Inventeur: THOMAS, Remy, 38130 ECHIROLLES (FR); BACQUET, Sylvain, 38470 CHASSELAY (FR); CASSARINO, Leandro, 33400 TALENCE (FR); DESPESSE, Ghislain, 38340 VOREPPE (FR); FERNANDEZ, Eric, 38760 SAINT PAUL DE VARCES (FR); LOPEZ, Yan, 38140 RENAGE (FR)
(74) Mandataire: Cabinet Beaumont
(86) Numéro de dépôt international: PCT/FR2019/050007
(87) Numéro de publication internationale: WO 2019/135051

(56) Documents cités:
- FR-A1- 2 976 365
- US-A1- 2014 347 060
- US-A1- 2014 365 792
- US-A1- 2017 047 747

## Description

### Domaine

La présente demande concerne le domaine des batteries à accumulateurs électriques commutés.

### Exposé de l'art antérieur

Une batterie comprend plusieurs accumulateurs électriques. Le fonctionnement de la batterie peut requérir l'estimation de l'état de charge de chaque accumulateur de la batterie. L'estimation de l'état de charge d'un accumulateur est généralement obtenue à partir de la mesure de la tension aux bornes de l'accumulateur. Pour certains types d'accumulateurs, par exemple des accumulateurs lithium fer phosphate appelés accumulateur LFP ou LiFe qui sont des accumulateurs électriques lithium-ion dont la cathode est faite en phosphate de fer lithié (LiFePO₄), la courbe d'évolution de la tension aux bornes de l'accumulateur en fonction de l'état de charge de l'accumulateur comprend une zone à pente faible de sorte que la seule mesure de la tension peut ne pas permettre l'estimation de l'état de charge avec une précision suffisante. Il peut alors être nécessaire de mesurer en outre le courant circulant dans l'accumulateur pour augmenter la précision de l'estimation de l'état de charge. L'estimation de l'état de charge de l'accumulateur est alors obtenue à partir du décompte des charges électriques entrant dans l'accumulateur et sortant de l'accumulateur.

Pour une batterie dans laquelle les accumulateurs sont connectés de façon statique les uns aux autres, il peut être utilisé un seul capteur de mesure de l'intensité du courant circulant entre les bornes de la batterie pour connaître le courant circulant dans chaque accumulateur.

Une batterie à accumulateurs commutés est une batterie comprenant plusieurs modules généralement identiques connectés en série et/ou en parallèle. Chaque module comprend une pluralité d'accumulateurs électriques. Des interrupteurs connectés en série et en parallèle avec les accumulateurs permettent de relier, ou non, en série et/ou en parallèle chaque accumulateur entre des noeuds de sortie du module, de manière à choisir la tension de sortie parmi les différentes combinaisons des tensions fournies par les accumulateurs.

Pour déterminer le courant circulant dans chaque accumulateur d'une batterie à accumulateurs commutés, une possibilité est d'utiliser un capteur de courant pour chaque accumulateur. Toutefois, ceci entraîne une augmentation du coût de fabrication de la batterie.

Les documents US 2017/047747 et US 2014/365792 décrivent des procédés de commande de batterie.

### Résumé

Ainsi, un objet d'un mode de réalisation est de pallier au moins en partie les inconvénients des procédés d'estimation de l'état de charge des accumulateurs des batteries à accumulateurs commutés décrites précédemment.

Un objet d'un mode de réalisation est que le nombre de capteurs de courant de la batterie est inférieur au nombre d'accumulateurs de la batterie.

Un objet d'un mode de réalisation est que l'estimation de l'état de charge de chaque accumulateur de la batterie est réalisée avec une précision améliorée.

Ainsi, un mode de réalisation prévoit un procédé de commande d'une batterie à accumulateurs électriques commutés selon la revendication 1.

Selon un mode de réalisation, le procédé comprend, en outre, pour au moins l'un des accumulateurs électriques connectés et à au moins un moment, successivement la mémorisation dans le deuxième compteur de la différence entre la valeur du premier compteur audit moment et la première donnée dudit accumulateur électrique et la mémorisation dans la première donnée de la valeur du premier compteur audit moment.

Selon un mode de réalisation, le premier compteur est mis à jour lorsque la batterie est en charge.

Selon un mode de réalisation, le procédé comprend en outre les étapes successives suivantes :
mettre à jour un troisième compteur représentatif de la quantité de charges circulant par la première borne à partir des mesures du capteur lorsque la batterie est en décharge ;
pour chaque accumulateur électrique, à chaque connexion de l'accumulateur électrique aux autres accumulateurs électriques, mémorisation dans une deuxième donnée de la valeur du troisième compteur à la connexion de l'accumulateur électrique et à chaque déconnexion de l'accumulateur électrique des autres accumulateurs électriques, mémorisation dans un quatrième compteur de la différence entre la valeur du troisième compteur à la déconnexion de l'accumulateur électrique et la deuxième donnée dudit accumulateur électrique.

Selon un mode de réalisation, le procédé comprend, en outre, pour au moins l'un des accumulateurs électriques connectés et à au moins un moment, successivement la mémorisation dans le quatrième compteur de la différence entre la valeur du deuxième compteur audit moment et la deuxième donnée dudit accumulateur électrique et la mémorisation dans la deuxième donnée de la valeur du troisième compteur audit moment.

Selon un mode de réalisation, le procédé comprend la transmission, par le premier circuit de commande aux deuxièmes circuits de commande, d'une commande représentative d'un nombre d'accumulateurs électriques à connecter et la détermination par au moins l'un des deuxièmes circuits de commande de commandes de connexion ou de déconnexion d'au moins l'un des accumulateurs électriques du module contenant ledit deuxième circuit de commande.

Un mode de réalisation prévoit également une batterie à accumulateurs électriques commutés selon la revendication 7.

Selon un mode de réalisation, la batterie comprend un seul capteur du courant circulant dans les accumulateurs électriques.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 représentent, de façon partielles et schématiques, des modes de réalisation d'une batterie d'accumulateurs ;
la figure 3 représente, de façon partielle et schématique, un exemple de module de la batterie de la figure 1 ou 2 ;
la figure 4 est un chronogramme illustrant un mode de réalisation d'un procédé de détermination des états de charge des accumulateurs d'une batterie ; et
la figure 5 est un schéma-bloc d'un mode de réalisation d'un cycle de commande de la batterie de la figure 1 ou 2.

### Description détaillée

De mêmes éléments ont été désignés par de mêmes références dans les différentes figures. Par souci de clarté, seuls les éléments utiles à la compréhension des modes de réalisation décrits ont été représentés et sont détaillés. En particulier, les fonctions classiques réalisées par les circuits de commande maître et esclave d'une batterie d'accumulateurs telles que l'équilibrage des accumulateurs sont bien connues de l'homme du métier et ne sont pas décrites plus en détail par la suite. Dans la suite de la description, les expressions "sensiblement", "environ", "approximativement" et "de l'ordre de" signifient "à 10 % près", de préférence à 5 % près.

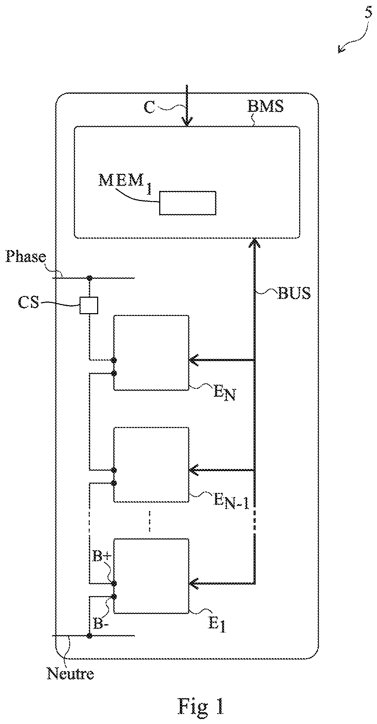

La figure 1 représente un mode de réalisation d'une batterie 5 à accumulateurs commutés. La batterie 5 comprend N modules E₁ à E_{N}. Le nombre N est un nombre entier pouvant être compris entre 1 et 50. Chaque module comprend une borne positive B+ et une borne négative B- et plusieurs accumulateurs électriques, non représentés, également appelés cellules, pouvant être connectées entre eux en série et/ou en parallèle par l'intermédiaire d'interrupteurs, non représentés, entre les bornes B+ et B-. Les modules E₁ à E_{N} peuvent être connectés en série entre une première borne Neutre de la batterie 5 et une deuxième borne Phase de la batterie 5.

La batterie 5 comprend un circuit BMS de commande des modules E₁ à E_{N}, appelé circuit de commande maître par la suite. Le circuit de commande maître BMS peut échanger des données avec chaque module E₁ à E_{N} par l'intermédiaire d'un bus bidirectionnel BUS de transmission de données. Chaque module E₁ à E_{N} comprend un circuit de commande, non représenté, des interrupteurs du module, appelé circuit de commande esclave par la suite, à partir des commandes fournies par le circuit de commande maître BMS. Chaque module E₁ à E_{N} comprend, en outre, des capteurs, non représentés, par exemple des capteurs de la tension aux bornes de chaque cellule du module, et/ou des capteurs de la température de chaque cellule du module. Le circuit de commande esclave de chaque module E₁ à E_{N} est adapté à transmettre au circuit de commande maître BMS des données représentatives des mesures de tensions, et/ou de températures par le bus de transmission de données BUS. La batterie comprend, en outre, un capteur CS de l'intensité du courant circulant par la borne Phase et relié au circuit de commande maître BMS. De préférence, la batterie 5 ne comprend pas d'autre capteur d'intensité de courant.

Le circuit de commande maître BMS peut correspondre à un circuit dédié et/ou peut comprendre un processeur, par exemple un microprocesseur ou un microcontrôleur, adapté à exécuter des instructions d'un programme d'ordinateur stocké dans une mémoire MEM1. Le circuit de commande maître BMS peut recevoir une consigne C, par exemple une consigne de tension, une consigne de courant, ou une consigne de nombre d'accumulateurs à connecter, et peut transmettre des données aux modules par l'intermédiaire du bus de transmission de données BUS à partir desquelles, pour chaque module, le circuit de commande esclave du module connecte ou déconnecte les cellules du module de façon à obtenir la tension, le courant et/ou le nombre de cellules connectés souhaités entre les bornes Phase et Neutre de la batterie 5.

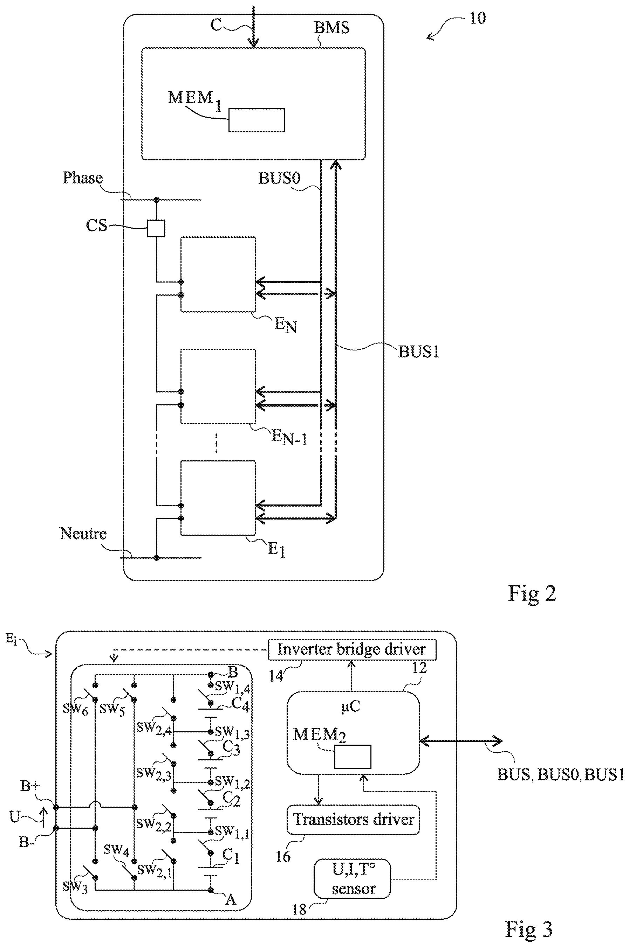

La figure 2 représente un autre mode de réalisation d'une batterie 10. La batterie 10 comprend l'ensemble des éléments de la batterie 5 représentée en figure 1 à la différence que le bus BUS est remplacé par deux bus BUS0 et BUS1 qui relient chacun le circuit de commande maître BMS à chaque module E₁ à E_{N}.

Le bus BUS0 est un bus rapide, c'est-à-dire un bus sur lequel des données sont transmises avec un débit supérieur à 3 mégabits par seconde, de préférence compris entre 5 mégabits par seconde et 7 mégabits par seconde. Le bus BUS0 peut être un bus unidirectionnel. A titre d'exemple, le bus BUS0 est un bus selon la norme RS485. Le bus BUS1 est un bus lent, c'est-à-dire sur lequel des données sont transmises avec un débit inférieur à 3 mégabits par seconde, de préférence compris entre 0,5 mégabits par seconde et 1 mégabit par seconde. Le bus BUS1 est un bus bidirectionnel. A titre d'exemple, le bus BUS1 est un bus de données CAN, notamment selon la norme ISO 11898. Le bus rapide BUS0 peut être utilisé pour la transmission de premières données fournies par le circuit de commande maître BMS aux circuits de commande esclaves pour suivre la consigne C. Le bus lent BUS1 peut être utilisé pour l'échange de toutes les autres données entre le circuit de commande maître BMS et chaque module E₁ à E_{N}.

La figure 3 représente un mode de réalisation du module Eᵢ, où i varie de 1 à N, chaque module E₁ à E_{N} pouvant avoir une structure analogue.

Selon le présent mode de réalisation, le module Eᵢ est adapté à fournir une tension Uᵢ entre la borne positive B+ et la borne négative B-. Le module Eᵢ comprend des cellules C₁ à C_{M} où M est un nombre entier compris entre 2 et 10, de préférence entre 2 et 5, quatre cellules C₁, C₂, C₃ et C₄ étant représentées à titre d'exemple en figure 3. Les cellules C₁ à C_{M} sont reliées entre elles et aux bornes B+ et B- par des interrupteurs. Dans le présent mode de réalisation, pour chaque cellule Cₖ, k étant un nombre entier variant de 1 à M, le module Eᵢ comprend un premier interrupteur SW_{1,k} en série avec la cellule Cₖ et un deuxième interrupteur SW_{2,k} en parallèle de l'ensemble comprenant la cellule Cₖ et l'interrupteur SW_{1,k}. Les M ensembles comprenant la cellule Cₖ et le premier interrupteur SW_{1,k} sont disposés en série entre un noeud A et un noeud B. La commande des interrupteurs SW_{1,k} et SW_{2,k'} k variant de 1 à M, permet de mettre en série entre les noeuds A et B, 1 à M cellules parmi les M cellules C₁ à C_{M}. Dans le présent mode de réalisation, le module Eᵢ comprend en outre un pont inverseur, également appelé pont en H, entre les noeuds A et B et les bornes B+ et B- qui permet d'appliquer la tension présente entre les noeuds A et B entre les bornes B+ et B- dans les deux sens. Selon un mode de réalisation, le pont inverseur comprend un interrupteur SW₃ reliant le noeud A à la borne B+, un interrupteur SW₄ reliant le noeud A à la borne B-, un interrupteur SW₅ reliant le noeud B à la borne B+ et un interrupteur SW₆ reliant le noeud B à la borne B-. A titre d'exemple chaque interrupteur SW_{1,k} et SW_{2,k'} k variant de 1 à M, SW₃, SW₄, SW₅ et SW₆ peut correspondre à un transistor à effet de champ à grille isolée, également appelé transistor MOS, notamment un transistor MOS de puissance, par exemple un transistor MOS à canal N.

Chaque module Eᵢ comprend, en outre, le circuit de commande esclave 12 (µC) adapté à échanger et/ou à recevoir des données émises par le circuit de commande maître BMS sur le bus BUS pour la batterie 5 ou sur les bus BUS0 et BUS1 pour la batterie 10. Le circuit de commande esclave 12 peut correspondre à un circuit dédié et/ou peut comprendre un processeur, par exemple un microprocesseur ou un microcontrôleur, adapté à exécuter des instructions d'un programme d'ordinateur stocké dans une mémoire MEM2 .

Chaque module Eᵢ comprend, en outre, un circuit de pilotage 14 (Inverter bridge driver) relié aux interrupteurs SW₃, SW₄, SW₅ et SW₆ du pont inverseur et un circuit de pilotage 16 (Transistors driver) relié aux interrupteurs SW_{1,k} et SW_{2,k}, k variant de 1 à M. Chaque circuit de pilotage 14, 16 est adapté à convertir les signaux de commande fournis par le circuit de commande esclave 12 en signaux adaptés à la commande des interrupteurs du module Eᵢ.

Chaque module Eᵢ comprend, en outre, des capteurs 18 (U, I, T° sensor) reliés au circuit de commande esclave 12. Le module Eᵢ peut comprendre, pour chaque cellule Cₖ, un capteur de température adapté à mesurer la température de la cellule Cₖ. Le module Eᵢ peut en outre comprendre, pour chaque cellule Cₖ, un capteur de tension adapté à mesurer la tension aux bornes de la cellule Cₖ. Le circuit de commande esclave 12 de chaque module Eᵢ est adapté à transmettre des données au circuit de commande maître BMS sur le bus BUS pour la batterie 5 ou sur le bus lent BUS1 pour la batterie 10 représentatives des mesures réalisées par les capteurs 18 du module Eᵢ. Le nombre et le type de capteurs dépend notamment de l'agencement des cellules du module Eᵢ.

Dans le mode de réalisation illustré en figure 3, une activation d'une cellule Cₖ d'un module Eᵢ signifie que la cellule Cₖ est mise en série entre les noeuds A et B du module Eᵢ, ce qui est obtenu en fermant l'interrupteur SW_{1,k} et en ouvrant l'interrupteur SW_{2,k'} et une désactivation d'une cellule Cₖ d'un module Eᵢ signifie que la connexion en série de la cellule Cₖ entre les noeuds A et B du module Eᵢ est interrompue, ce qui est obtenu en ouvrant l'interrupteur SW_{1,k} et en fermant l'interrupteur SW_{2,k}.

Les commandes d'activation et de désactivation des cellules peuvent être réalisées selon différents modes de réalisation. Selon un mode de réalisation, le circuit de commande maître BMS transmet une commande d'activation/de désactivation spécifique au circuit de commande esclave 12 d'un module Eᵢ contenant une cellule Cₖ à activer ou à désactiver. Un avantage d'un tel mode de réalisation est que seuls les circuits de commande esclaves des modules contenant des cellules à activer ou à désactiver sont sollicités. La structure de chaque circuit de commande esclave peut être simple. En outre, des circuits de commande esclaves différents peuvent être sollicités sur des temps rapprochés. Selon un autre mode de réalisation, le circuit de commande maître BMS transmet à chaque circuit de commande esclave 12 une consigne de tension ou de courant à fournir par la batterie ou une consigne de nombre total de cellules à connecter. Le circuit de commande esclave 12 de chaque module Eᵢ détermine alors quelles cellules du module doivent être activées/désactivées pour suivre la consigne. Un tel mode de réalisation présente l'avantage de permettre de grandes amplitudes de variations de tension à chaque nouvelle consigne.

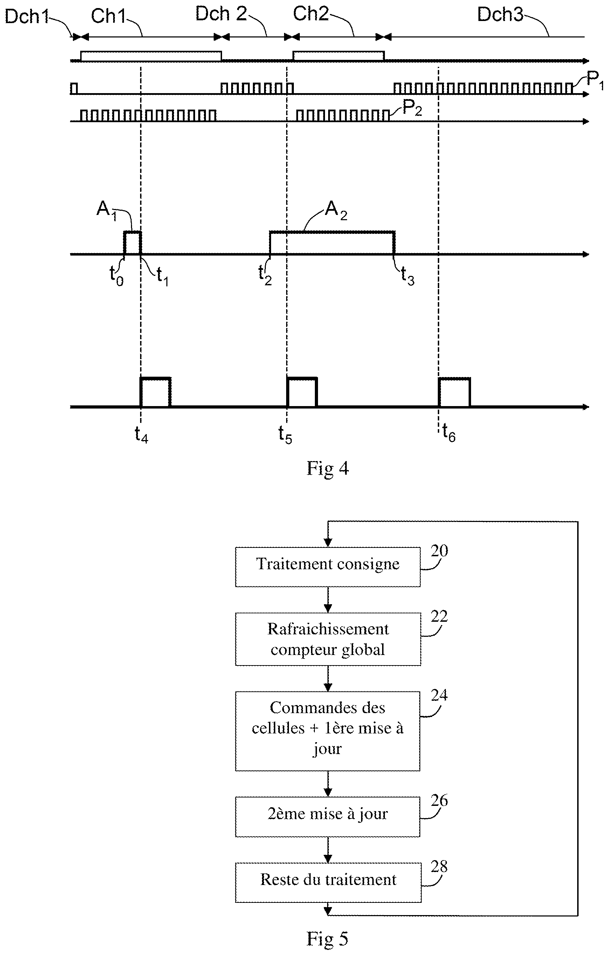

La figure 4 est un chronogramme illustrant un mode de réalisation d'un procédé de détermination de l'état de charge de chaque cellule Cₖ de la batterie 5 ou 10. On a représenté en figure 4 des phases de fonctionnement de la batterie 5 ou 10 comprenant successivement une phase de décharge Dch1, une phase de charge Ch1, une phase de décharge Dch2, une phase de charge Ch2 et une phase de décharge Dch3.

Selon un mode de réalisation, le circuit de commande maître BMS utilise deux compteurs globaux Cptr_AhCh et Cptr_AhDch. Le premier compteur global Cptr_AhCh est représentatif du nombre total de charges circulant dans la batterie lorsque la batterie est en charge. Le deuxième compteur global Cptr AhDch est représentatif du nombre total de charges circulant dans la batterie lorsque la batterie est en décharge. Chaque compteur global Cptr_AhCh, Cptr_AhDch est déterminé à partir de l'intensité du courant mesuré par le capteur CS. Selon un mode de réalisation, chaque compteur global Cptr_AhCh, Cptr_AhDch est rafraîchi de façon régulière, par exemple périodique, par exemple toutes les 50 ps, par le circuit de commande maître BMS et est mémorisé dans la mémoire MEM1. A titre d'exemple, lorsque la batterie est en charge, le compteur global Cptr_AhDch reste inchangé et le compteur global Cptr_AhCh est augmenté à chaque rafraîchissement d'une valeur représentative du produit de l'intensité du courant mesuré par le capteur CS et de la durée écoulée depuis le dernier rafraîchissement. A titre d'exemple, lorsque la batterie est en décharge, le compteur global Cptr_AhCh reste inchangé et le compteur global Cptr_AhDch est augmenté à chaque rafraîchissement d'une valeur représentative du produit de l'intensité du courant mesuré par le capteur CS et de la durée écoulée depuis le dernier rafraîchissement. En figure 4, on a représenté de façon schématique par des impulsions P1 le rafraîchissement du compteur global Cptr_AhDch et par des impulsions P2 le rafraîchissement du compteur global Cptr_AhCh.

Selon un mode de réalisation, pour chaque cellule Cₖ, il est utilisé deux compteurs locaux AhChₖ et AhDchₖ. Le premier compteur local AhChₖ est représentatif d'une estimation du nombre total de charges électriques ayant circulé dans la cellule Cₖ lorsque la cellule Cₖ est en charge. Le deuxième compteur local AhDchₖ est représentatif d'une estimation du nombre total de charges électriques ayant circulé dans la cellule Cₖ lorsque la cellule Cₖ est en décharge. Pour chaque cellule Cₖ, les compteurs locaux AhChₖ et AhDchₖ peuvent être mémorisés dans la mémoire MEM1 du circuit de commande maître BMS ou dans la mémoire MEM2 du circuit de commande esclave 12 du module Eᵢ contenant la cellule Cₖ.

Selon un mode de réalisation, pour chaque cellule Cₖ, le compteur local AhChₖ est mis à jour à partir du compteur global Cptr_AhCh et le compteur local AhDchₖ est mis à jour à partir du compteur global Cptr_AhDch. Selon un mode de réalisation, le procédé comprend deux opérations différentes de mise à jour des compteurs locaux AhChₖ et AhDchₖ pour chaque cellule Cₖ.

Selon la première opération de mise à jour, les compteurs locaux AhChₖ et AhDchₖ de la cellule Cₖ sont mis à jour à chaque fois que la cellule Cₖ est désactivée. Plus précisément, il est utilisé, pour chaque cellule Cₖ, des données SnapAhChₖ et SnapAhDchₖ. Les données SnapAhChₖ et SnapAhDchₖ peuvent être mémorisées dans la mémoire MEM1 du circuit de commande maître BMS ou dans la mémoire MEM2 du circuit de commande esclave 12 du module Eᵢ contenant la cellule Cₖ. Lorsque la cellule Cₖ est activée, il est mémorisé dans la donnée SnapAhChₖ la valeur courante du compteur Cptr_AhCh et il est mémorisé dans la donnée SnapAhDchₖ la valeur courante du compteur Cptr_AhDch indépendamment du fait que la cellule Cₖ est en charge ou en décharge. Lorsque la cellule Cₖ est désactivée, indépendamment du fait que la cellule Cₖ est en charge ou en décharge, le compteur AhChₖ est mis à jour, c'est-à-dire qu'il est mémorisé dans le compteur AhChₖ la différence entre la valeur courante du compteur Cptr_AhCh au moment où la cellule Cₖ est désactivée et la donnée SnapAhChₖ et le compteur AhDchₖ est mis à jour, c'est-à-dire qu'il est mémorisé dans le compteur AhDchₖ la différence entre la valeur courante du compteur Cptr_AhDch au moment où la cellule Cₖ est désactivée et la donnée SnapAhDchₖ.

En figure 4, on a représenté, pour une cellule Cₖ, deux phases A1 et A2 pendant lesquelles la cellule Cₖ est activée. La phase A1 débute par l'activation de la cellule Cₖ à l'instant t0 et s'achève par la désactivation de la cellule Cₖ à l'instant t1. La phase A2 débute par l'activation de la cellule Cₖ à l'instant t2 et s'achève par la désactivation de la cellule Cₖ à l'instant t3. Comme cela apparaît sur la figure 4, la batterie est en charge pendant la totalité de la phase A1 alors que la phase A2 débute alors que la batterie est en décharge et s'achève alors que la batterie est en charge.

A l'instant t0, il est mémorisé dans la donnée SnapAhChₖ la valeur du compteur Cptr_AhCh à l'instant t0 et il est mémorisé dans la donnée SnapAhDchₖ la valeur du compteur Cptr_AhDch à l'instant t0. A l'instant t1, il est mémorisé dans le compteur AhChₖ la différence entre la valeur courante du compteur Cptr_AhCh à l'instant t1 et la donnée SnapAhChₖ et il est mémorisé dans le compteur AhDchₖ la différence entre la valeur courante du compteur Cptr_AhDch à l'instant t1 et la donnée SnapAhDchₖ. A l'instant t2, il est mémorisé dans la donnée SnapAhChₖ la valeur du compteur Cptr_AhCh à l'instant t2 et il est mémorisé dans la donnée SnapAhDchₖ la valeur du compteur Cptr_AhDch à l'instant t2. A l'instant t3, il est mémorisé dans le compteur AhChₖ la différence entre la valeur courante du compteur Cptr_AhCh à l'instant t3 et la donnée SnapAhChₖ et il est mémorisé dans le compteur AhDchₖ la différence entre la valeur courante du compteur Cptr _AhDch à l'instant t3 et la donnée SnapAhDchₖ.

Selon la deuxième opération de mise à jour, les compteurs locaux AhChₖ et AhDchₖ de la cellule Cₖ sont mis à jour de façon périodique pendant toute la durée d'utilisation de la cellule Cₖ. Ceci permet d'assurer une mise à jour régulière des compteurs locaux AhChₖ et AhDchₖ de la cellule Cₖ même si la cellule Cₖ reste activée longtemps alors que, avec la première opération de mise à jour, les compteurs locaux AhChₖ et AhDchₖ ne sont mis à jour qu'à la désactivation de la cellule Cₖ. Selon un mode de réalisation, la deuxième opération de mise à jour comprend :
la mise à jour du compteur AhChₖ, c'est-à-dire qu'il est mémorisé dans le compteur AhChₖ la différence entre la valeur courante du compteur Cptr_AhCh et la donnée SnapAhChₖ ;
la mise à jour du compteur AhDchₖ, c'est-à-dire qu'il est mémorisé dans le compteur AhDchₖ la différence entre la valeur courante du compteur Cptr_AhDch et la donnée SnapAhDchₖ ;
la mémorisation dans la donnée SnapAhChₖ de la valeur courante du compteur Cptr_AhCh ; et
la mémorisation dans la donnée SnapAhDchₖ de la valeur courante du compteur Cptr_AhDch.

En figure 4, pour une cellule Cₘ qui est activée, la deuxième opération de mise à jour est réalisée aux instants t4, t5 et t6.

Selon un autre mode de réalisation, un seul compteur global Cptr_Ah de charges électriques est utilisé que la batterie soit en charge ou en décharge. Le compteur global Cptr_Ah est alors incrémenté lors d'une opération de charge de la batterie et est décrémenté lors d'une opération de décharge de la batterie à partir des mesures d'intensité du courant fournies par le capteur CS. En outre, pour chaque cellule Cₖ, un seul compteur local Ahₖ et une seule donnée SnapAhₖ sont utilisées.

Selon la première opération de mise à jour, le compteur local Ahₖ de la cellule Cₖ est mis à jour à chaque fois que la cellule Cₖ est désactivée. Plus précisément, lorsque la cellule Cₖ est activée, il est mémorisé dans la donnée SnapAhₖ la valeur courante du compteur Cptr_Ah. Lorsque la cellule Cₖ est désactivée, le compteur Ahₖ est mis à jour, c'est-à-dire qu'il est mémorisé dans le compteur Ahₖ la différence entre la valeur courante du compteur Cptr_Ah et la donnée SnapAhₖ.

Selon la deuxième opération de mise à jour, de façon régulière, par exemple périodique, lorsque la cellule Cₖ est activée, le compteur Ahₖ est mis à jour, c'est-à-dire qu'il est mémorisé dans le compteur Ahₖ la différence entre la valeur courante du compteur Cptr_Ah et la donnée SnapAhₖ, et il est mémorisé dans la donnée SnapAhₖ la valeur courante du compteur Cptr_Ah.

Le circuit de commande maître BMS peut déterminer l'état de charge de la cellule Cₖ à partir la donnée Ahₖ. Le circuit de commande maître BMS peut mettre en oeuvre un procédé d'équilibrage des cellules à partir de la détermination de l'état de charges des cellules.

La figure 5 est un schéma-bloc d'un mode de réalisation d'un cycle de commande de la batterie de la figure 1 ou 2.

A l'étape 20, le circuit de commande maître BMS détermine les données à transmettre aux modules E₁ à E_{N} à partir de la consigne C. Le procédé se poursuit à l'étape 22.

A l'étape 22, le circuit de commande maître BSM met à jour les compteurs globaux Cptr_AhCh et Cptr_AhDch ou le compteur global Cptr_AhCh. Le procédé se poursuit à l'étape 24.

A l'étape 24, le circuit de commande maître BMS transmet des données aux circuits de commande esclaves 12 des modules E₁ à E_{N} pouvant entraîner l'activation d'au moins une cellule qui était désactivée et/ou la désactivation d'au moins une cellule qui était activée. La première opération de mise à jour des compteurs locaux est réalisée pour chaque cellule qui est activée et pour chaque cellule qui est désactivée. Le procédé se poursuit à l'étape 26.

A l'étape 26, la deuxième opération de mise à jour est réalisée. Selon un mode de réalisation, la deuxième opération de mise à jour est mise en oeuvre pour un nombre déterminé de cellules qui sont activées, par exemple pour une seule cellule qui est activée. La durée de l'étape 26 est alors, de façon avantageuse, bornée. Selon un mode de réalisation, une liste des cellules qui sont activées est conservée dans la mémoire MEM1 et, à chaque cycle, la deuxième opération de mise à jour est réalisée pour une cellule activée différente de la liste de cellules activées. Le procédé se poursuit à l'étape 28.

A l'étape 28, le reste du cycle de commande est mis en oeuvre.

Le mode de réalisation décrit précédemment en relation avec la figure 5 permet de façon avantageuse que la deuxième opération de mise à jour mise en oeuvre à l'étape 26 n'interfère pas avec les autres opérations réalisées par le circuit de commande maître BMS ou les circuits de commande esclaves 12.

Selon un mode de réalisation, à l'étape 24, la première opération de mise à jour d'une cellule qui est activée ou désactivée peut être réalisée principalement par le circuit de commande maître BMS. Dans ce cas, les données SnapAhChₖ et SnapAhDchᵢ ou la donnée SnapAhᵢ de chaque cellule Cᵢ sont stockées dans la mémoire MEM1 du circuit de commande maître BMS. Pour chaque cellule Cₖ à activer, le circuit de commande maître BMS transmet au circuit de commande esclave 12 du module Eᵢ contenant la cellule Cₖ met à jour les données SnapAhChₖ et SnapAhDchₖ ou la donnée SnapAhₖ de la cellule Cₖ à partir des valeurs courantes des compteurs globaux Cptr_AhDch et Cptr_AhCh ou de la valeur courante du compteur global Cptr_Ah associées au circuit de commande esclave 12 du module Eⱼ contenant la cellule Cₖ et, pour chaque cellule Cₘ à désactiver, le circuit de commande maître BMS met à jour les compteurs locaux AhChₘ et AhDchₘ ou le compteur global Ahₘ de la cellule Cₘ à partir des valeurs courantes des compteurs globaux Cptr_AhDch et Cptr_AhCh ou de la valeur courante du compteur global Cptr_Ah associées au circuit de commande esclave 12 du module Eⱼ contenant la cellule Cₖ.

Selon un autre mode de réalisation, à l'étape 24, la première opération de mise à jour d'une cellule qui est activée ou désactivée peut être réalisée au moins en partie par le circuit de commande esclave 12 du module contenant cette cellule. Dans ce cas, le circuit de commande maître BMS transmet à chaque circuit de commande esclave 12 les valeurs courantes des compteurs globaux Cptr_AhDch et Cptr_AhCh ou la valeur courante du compteur global Cptr_Ah et c'est le circuit de commande esclave 12 du module Eᵢ contenant la cellule Cₖ à activer qui initie la mise à jour des données SnapAhChₖ et SnapAhDchₖ ou de la donnée SnapAhₖ de la cellule Cₖ et la mise à jour des compteurs locaux AhChₘ et AhDchₘ ou du compteur global Ahₘ de la cellule Cₘ à désactiver. Ceci permet de façon avantageuse de réduire les calculs à réaliser par le circuit de commande maître BMS.

Des modes de réalisation particuliers ont été décrits. Diverses variantes et modifications apparaîtront à l'homme de l'art. En particulier, les transistors constituant les interrupteurs dans des cellules peuvent être remplacés par d'autres types d'interrupteurs selon les besoins du circuit. En outre, bien que dans les exemples décrits précédemment, les cellules soient connectées en série lorsqu'elles sont activées, les cellules peuvent, de façon générale, être connectées en série et/ou en parallèle. Dans ce cas, la valeur des compteurs globaux Cptr_AhDch et Cptr_AhCh ou du compteur global Cptr_Ah utilisées pour la mise à jour des compteurs locaux AhDchₖ et AhChₖ ou du compteur local Ahₖ et des données SnapAhChₖ et SnapAhDchₖ ou de la donnée SnapAhₖ de la cellule Cₖ sont pondérées en fonction du nombre de cellules activées en parallèle.

Divers modes de réalisation avec diverses variantes ont été décrits ci-dessus. On notera que l'homme de l'art pourra combiner divers éléments de ces divers modes de réalisation et variantes sans faire preuve d'activité inventive.

## Revendications

1. Procédé de commande d'une batterie (5 ; 10) à accumulateurs électriques commutés, la batterie comprenant un premier circuit de commande (BMS) et plusieurs modules (Eᵢ) disposés entre des première et deuxième bornes (Phase, Neutre), chaque module (Eᵢ) comprenant des troisième et quatrième bornes (B+, B-), au moins l'une des troisième et quatrième bornes de chaque module étant reliée à l'une des troisième et quatrième bornes d'un autre module, chaque module comprenant des accumulateurs électriques (C₁, C₂, C₃, C₄) et des interrupteurs reliant les accumulateurs entre eux et aux troisième et quatrième bornes du module et un deuxième circuit de commande (12) des interrupteurs, la batterie comprenant en outre au moins un bus de transmission de données (BUS ; BUS0, BUS1) reliant le premier circuit de commande à chaque deuxième circuit de commande et un capteur (CS) du courant passant par la première borne, le nombre de capteurs de courant de la batterie étant inférieur au nombre d'accumulateurs électriques de la batterie, le procédé comprenant la réception par le premier circuit de commande (BMS) d'une nouvelle consigne (C) de fourniture d'une tension, d'un courant et/ou d'un nombre d'accumulateurs électriques à connecter entre les première et deuxième bornes (Phase, Neutre) et comprenant la transmission, par le premier circuit de commande (BMS) aux deuxièmes circuits de commande (12), de commandes de connexion ou de déconnexion d'au moins l'un des accumulateurs électriques (C₁, C₂, C₃, C₄) des modules (Eᵢ) pour suivre ladite consigne (C),
le procédé étant **caractérisé en ce qu'**il comprend les étapes successives suivantes :
mettre à jour un premier compteur représentatif de la quantité de charges circulant par la première borne à partir des mesures du capteur ;
pour chaque accumulateur électrique, à chaque connexion de l'accumulateur électrique aux autres accumulateurs électriques, mémorisation dans une première donnée de la valeur du premier compteur à la connexion de l'accumulateur électrique et à chaque déconnexion de l'accumulateur électrique des autres accumulateurs électriques, mémorisation d'un deuxième compteur égal à la différence entre la valeur du premier compteur à la déconnexion de l'accumulateur électrique et la première donnée dudit accumulateur électrique.

2. Procédé selon la revendication 1, comprenant, en outre, pour au moins l'un des accumulateurs électriques (C₁, C₂, C₃, C₄) connectés et à au moins un moment, successivement la mémorisation dans le deuxième compteur de la différence entre la valeur du premier compteur audit moment et la première donnée dudit accumulateur électrique et la mémorisation dans la première donnée de la valeur du premier compteur audit moment.

3. Procédé selon la revendication 1 ou 2, dans lequel le premier compteur est mis à jour lorsque la batterie (5, 10) est en charge.

4. Procédé selon la revendication 3, comprenant en outre les étapes successives suivantes :
mettre à jour un troisième compteur représentatif de la quantité de charges circulant par la première borne à partir des mesures du capteur lorsque la batterie (5, 10) est en décharge ;
pour chaque accumulateur électrique (C₁, C₂, C₃, C₄), à chaque connexion de l'accumulateur électrique aux autres accumulateurs électriques, mémorisation dans une deuxième donnée de la valeur du troisième compteur à la connexion de l'accumulateur électrique et à chaque déconnexion de l'accumulateur électrique des autres accumulateurs électriques, mémorisation dans un quatrième compteur de la différence entre la valeur du troisième compteur à la déconnexion de l'accumulateur électrique et la deuxième donnée dudit accumulateur électrique.

5. Procédé selon la revendication 4, comprenant, en outre, pour au moins l'un des accumulateurs électriques (C₁, C₂, C₃, C₄) connectés et à au moins un moment, successivement la mémorisation dans le quatrième compteur de la différence entre la valeur du deuxième compteur audit moment et la deuxième donnée dudit accumulateur électrique et la mémorisation dans la deuxième donnée de la valeur du troisième compteur audit moment.

6. Procédé selon l'une quelconque des revendications 1 à 5, comprenant la transmission, par le premier circuit de commande (BMS) aux deuxièmes circuits de commande (12), d'une commande représentative d'un nombre d'accumulateurs électriques (C₁, C₂, C₃, C₄) à connecter et la détermination par au moins l'un des deuxièmes circuits de commande (12) de commandes de connexion ou de déconnexion d'au moins l'un des accumulateurs électriques du module (Eᵢ) contenant ledit deuxième circuit de commande.

7. Batterie (5 ; 10) à accumulateurs électriques commutés, comprenant un premier circuit de commande (BMS) et plusieurs modules (Eᵢ) disposés entre des première et deuxième bornes (Phase, Neutre), chaque module (Eᵢ) comprenant des troisième et quatrième bornes (B+, B-), au moins l'une des troisième et quatrième bornes de chaque module étant reliée à l'une des troisième et quatrième bornes d'un autre module, chaque module comprenant des accumulateurs électriques (C₁, C₂, C₃, C₄) et des interrupteurs reliant les accumulateurs entre eux et aux troisième et quatrième bornes du module et un deuxième circuit de commande (12) des interrupteurs, la batterie comprenant en outre au moins un bus de transmission de données (BUS ; BUS0, BUS1) reliant le premier circuit de commande à chaque deuxième circuit de commande et un capteur (CS) du courant passant par la première borne, le nombre de capteurs de courant de la batterie étant inférieur au nombre d'accumulateurs électriques de la batterie, le premier circuit de commande (BMS) étant adapté à recevoir une nouvelle consigne (C) de fourniture d'une tension, d'un courant et/ou d'un nombre d'accumulateurs électriques à connecter entre les première et deuxième bornes (Phase, Neutre) et à transmettre aux deuxièmes circuits de commande (12), des commandes de connexion ou de déconnexion d'au moins l'un des accumulateurs électriques (C₁, C₂, C₃, C₄) des modules (Eᵢ) pour suivre ladite consigne (C),
la batterie étant **caractérisée en ce que** le premier circuit de commande étant adapté à mettre à jour un premier compteur représentatif de la quantité de charges circulant par la première borne à partir des mesures du capteur, et, pour chaque accumulateur électrique, à chaque connexion de l'accumulateur électrique aux autres accumulateurs électriques, le premier circuit de commande ou le deuxième circuit de commande associé audit accumulateur électrique étant adapté à mémoriser dans une première donnée la valeur du premier compteur à la connexion de l'accumulateur électrique et à chaque déconnexion de l'accumulateur électrique des autres accumulateurs électriques, étant adapté à mémoriser dans un deuxième compteur la différence entre la valeur du premier compteur à la déconnexion de l'accumulateur électrique et la première donnée dudit accumulateur électrique.

8. Batterie selon la revendication 7, comprenant un seul capteur du courant circulant dans les accumulateurs électriques (C₁, C₂, C₃, C₄).

## Patentansprüche

1. Verfahren zur Steuerung einer Batterie (5; 10) mit geschalteten elektrischen Zellen, wobei die Batterie eine erste Steuerschaltung (BMS) und eine Vielzahl von Modulen (Ei) aufweist, die zwischen einem ersten und einem zweiten Anschluss (Phase, Neutral) angeordnet sind, wobei jedes Modul (Ei) einen dritten und einen vierten Anschluss (B+, B-) aufweist, wobei mindestens einer der dritten und vierten Anschlüsse jedes Moduls mit einem der dritten und vierten Anschlüsse eines anderen Moduls gekoppelt ist, wobei jedes Modul elektrische Zellen (C1, C2, C3, C4) und Schalter aufweist, die die Zellen untereinander und mit dem dritten und vierten Anschluss des Moduls koppeln, sowie eine zweite Schaltersteuerschaltung (12), wobei die Batterie ferner mindestens einen Datenübertragungsbus (BUS; BUSO, BUS1), der die erste Steuerschaltung mit jeder zweiten Steuerschaltung koppelt, und einen Sensor (CS) für den durch den ersten Anschluss fließenden Strom aufweist, wobei die Anzahl der Stromsensoren der Batterie geringer ist als die Anzahl der elektrischen Zellen der Batterie, wobei das Verfahren den Empfang eines neuen Sollwerts (C) für die Abgabe einer Spannung durch die erste Steuerschaltung (BMS) aufweist, eines Stroms und/oder einer Anzahl elektrischer Zellen, die zwischen den ersten und den zweiten Anschluss (Phase, Neutral) anzuschließen sind, und das die Übertragung aufweist, und zwar durch die erste Steuerschaltung (BMS) an die zweiten Steuerschaltungen (12), von Steuersignalen für den Anschluss oder die Trennung von mindestens einer der elektrischen Zellen (C1, C2, C3, C4) der Module (Ei), um dem Sollwert (C) zu folgen,
wobei das Verfahren **dadurch gekennzeichnet ist, dass** es die folgenden aufeinanderfolgenden Schritte aufweist:
Aktualisieren eines ersten Zählers, der für die durch den ersten Anschluss fließende Ladungsmenge repräsentativ ist, und zwar auf Grundlage der Sensormessungen;
für jede elektrische Zelle, für jede Verbindung der elektrischen Zelle mit den anderen elektrischen Zellen, Speichern, in ersten Daten, des Wertes des ersten Zählers bei der Verbindung der elektrischen Zelle und für jede Trennung der elektrischen Zelle von den anderen elektrischen Zellen, Speichern eines zweiten Zählers, der gleich der Differenz zwischen dem Wert des ersten Zählers bei der Trennung der elektrischen Zelle und den ersten Daten der genannten elektrischen Zelle ist.

2. Verfahren nach Anspruch 1, das ferner für mindestens eine der angeschlossenen elektrischen Zellen (C1, C2, C3, C4) und zu mindestens einem Zeitpunkt nacheinander die Speicherung in den zweiten Zähler der Differenz zwischen dem Wert des ersten Zählers zu diesem Zeitpunkt und den ersten Daten der elektrischen Zelle und die Speicherung in die ersten Daten des Wertes des ersten Zählers zu diesem Zeitpunkt aufweist.

3. Verfahren nach Anspruch 1 oder 2, wobei der erste Zähler aktualisiert wird, wenn sich die Batterie (5, 10) im Lademodus befindet.

4. Verfahren nach Anspruch 3, das ferner die folgenden aufeinanderfolgenden Schritte aufweist:
Aktualisieren eines dritten Zählers, der die Menge der durch den ersten Anschluss fließenden Ladungen repräsentiert, und zwar auf der Grundlage der Sensormessungen, wenn sich die Batterie (5, 10) im Entladungsmodus befindet;
für jede elektrische Zelle (C1, C2, C3, C4), für jede Verbindung der elektrischen Zelle mit den anderen elektrischen Zellen, Speichern in zweiten Daten des Wertes des dritten Zählers bei der Verbindung der elektrischen Zelle und für jede Trennung der elektrischen Zelle von den anderen elektrischen Zellen, Speichern in einem vierten Zähler der Differenz zwischen dem Wert des dritten Zählers bei der Trennung der elektrischen Zelle und den zweiten Daten der genannten elektrischen Zelle.

5. Verfahren nach Anspruch 4, ferner aufweisend für mindestens eine der angeschlossenen elektrischen Zellen (C1, C2, C3, C4) und zu mindestens einem Zeitpunkt nacheinander die Speicherung in den vierten Zähler der Differenz zwischen dem Wert des zweiten Zählers zu diesem Zeitpunkt und den zweiten Daten dieser elektrischen Zelle und die Speicherung in die zweiten Daten des Wertes des dritten Zählers zu diesem Zeitpunkt.

6. Verfahren nach einem der Ansprüche 1 bis 5, das die Übertragung durch die erste Steuerschaltung (BMS) an die zweite Steuerschaltung (12) aufweist, und zwar eines Steuersignals, das für eine Anzahl von anzuschließenden elektrischen Zellen (C1, C2, C3, C4) repräsentativ ist, und die Bestimmung, durch mindestens eine der zweiten Steuerschaltungen (12) aufweist, und zwar von Steuersignalen für den Anschluss oder die Trennung von mindestens einer der elektrischen Zellen des Moduls (Ei), das die zweite Steuerschaltung enthält.

7. Eine Batterie (5; 10) mit geschalteten elektrischen Zellen, die eine erste Steuerschaltung (BMS) und eine Vielzahl von Modulen (Ei) aufweist, die zwischen einem ersten und einem zweiten Anschluss (Phase, Neutral) angeordnet sind, wobei jedes Modul (Ei) einen dritten und einen vierten Anschluss (B+, B-) aufweist, wobei mindestens einer der dritten und vierten Anschlüsse jedes Moduls mit einem der dritten und vierten Anschlüsse eines anderen Moduls verbunden ist, wobei jedes Modul elektrische Zellen (C1, C2, C3, C4) und Schalter aufweist, die die Zellen untereinander und mit den dritten und vierten Anschlüssen des Moduls koppeln, sowie eine zweite Schaltersteuerschaltung (12), wobei die Batterie außerdem mindestens einen Datenübertragungsbus (BUS ; BUSO, BUS1), der die erste Steuerschaltung mit jedem zweiten Steuerkreis koppelt, und einen Sensor (CS) für den durch den ersten Anschluss fließenden Strom aufweist, wobei die Anzahl der Stromsensoren der Batterie geringer ist als die Anzahl der elektrischen Zellen der Batterie, wobei die erste Steuerschaltung (BMS) eingerichtet ist, einen neuen Sollwert (C) für die Abgabe einer Spannung, eines Stroms eines Stroms und/oder einer Anzahl von elektrischen Zellen, die zwischen den ersten und zweiten Anschluss (Phase, Neutral) anzuschließen sind, zu empfangen und an die zweiten Steuerschaltungen (12) Steuersignale für den Anschluss oder die Abschaltung von mindestens einer der elektrischen Zellen (C1, C2, C3, C4) der Module (Ei) zu übertragen, um dem genannten Sollwert (C) zu folgen,
wobei die Batterie **dadurch gekennzeichnet ist, dass** die erste Steuerschaltung in der Lage ist, einen ersten Zähler zu aktualisieren, der für die durch den ersten Anschluss fließende Ladungsmenge repräsentativ ist, und zwar auf Grundlage der Sensormessungen und, wobei für jede elektrische Zelle, für jede Verbindung der elektrischen Zelle mit den anderen elektrischen Zellen, die erste Steuerschaltung oder die zweite Steuerschaltung, die mit der genannten elektrischen Zelle verbunden ist, in der Lage ist, den Wert des ersten Zählers beim Anschluss der elektrischen Zelle in ersten Daten zu speichern, und für jede Trennung der elektrischen Zelle von den anderen elektrischen Zellen in der Lage ist, die Differenz zwischen dem Wert des ersten Zählers beim Trennen der elektrischen Zelle und den ersten Daten der genannten elektrischen Zelle in einem zweiten Zähler zu speichern.

8. Batterie nach Anspruch 7, die einen einzigen Sensor für den Strom aufweist, der durch die elektrischen Zellen (C1, C2, C3, C4) fließt.

## Claims

1. A method of controlling a battery (5; 10) having switched electric cells, the battery comprising a first control circuit (BMS) and a plurality of modules (Eᵢ) arranged between first and second terminals (Phase, Neutral), each module (Eᵢ) comprising third and fourth terminals (B+, B-), at least one of the third and fourth terminals of each module being coupled to one of the third and fourth terminals of another module, each module comprising electric cells (C₁, C₂, C₃, C₄) and switches coupling the cells to one another and to the third and fourth terminals of the module and a second switch control circuit (12), the battery further comprising at least one data transmission bus (BUS; BUS0, BUS1) coupling the first control circuit to each second control circuit and a sensor (CS) of the current flowing through the first terminal, the number of current sensors of the battery being inferior to the number of electric cells of the battery, the method comprising the reception by the first control circuit (BMS) of a new set point (C) for the delivery of a voltage, of a current, and/or of a number of electric cells to be connected between the first and second terminals (Phase, Neutral) and comprising the transmission, by the first control circuit (BMS) to the second control circuits (12), of control signals for the connection or the disconnection of at least one of the electric cells (C₁, C₂, C₃, C₄) of the modules (Eᵢ) to follow said set point (C),
the method being **characterized in that** it comprises the successive steps of:
updating a first counter representative of the quantity of charges flowing through the first terminal based on the sensor measurements;
for each electric cell, for each connection of the electric cell to the other electric cells, storing into first data the value of the first counter on connection of the electric cell and for each disconnection of the electric cell from the other electric cells, storing a second counter equal to the difference between the value of the first counter on disconnection of the electric cell and the first data of said electric cell.

2. The method according to claim 1, further comprising, for at least one of the connected electric cells (C₁, C₂, C₃, C₄) and at at least one time, successively the storage into the second counter of the difference between the value of the first counter at said time and the first data of said electric cell and the storage into the first data of the value of the first counter at said time.

3. The method according to claim 1 or 2, wherein the first counter is updated when the battery (5, 10) is in charge mode.

4. The method according to claim 3, further comprising the successive steps of:
updating a third counter representative of the quantity of charges flowing through the first terminal based on the sensor measurements when the battery (5, 10) is in discharge mode;
for each electric cell (C₁, C₂, C₃, C₄), for each connection of the electric cell to the other electric cells, storing into second data the value of the third counter on connection of the electric cell and for each disconnection of the electric cell from the other electric cells, storing into a fourth counter the difference between the value of the third counter on disconnection of the electric cell and the second data of said electric cell.

5. The method according to claim 4, further comprising, for at least one of the connected electric cells (C₁, C₂, C₃, C₄) and at at least one time, successively the storage into the fourth counter of the difference between the value of the second counter at said time and the second data of said electric cell and the storage into the second data of the value of the third counter at said time.

6. The method according to any of claims 1 to 5, comprising the transmission, by the first control circuit (BMS) to the second control circuits (12), of a control signal representative of a number of electric cells (C₁, C₂, C₃, C₄) to be connected and the determination by at least one of the second control circuits (12) of control signals for the connection or the disconnection of at least one of the electric cells of the module (Eᵢ) containing said second control circuit.

7. A battery (5; 10) having switched electric cells, comprising a first control circuit (BMS) and a plurality of modules (Eᵢ) arranged between first and second terminals (Phase, Neutral), each module (Eᵢ) comprising third and fourth terminals (B+, B-), at least one of the third and fourth terminals of each module being coupled to one of the third and fourth terminals of another module, each module comprising electric cells (C₁, C₂, C₃, C₄) and switches coupling the cells to one another and to the third and fourth terminals of the module and a second switch control circuit (12), the battery further comprising at least one data transmission bus (BUS ; BUS0, BUS1) coupling the first control circuit to each second control circuit and a sensor (CS) of the current flowing through the first terminal, the number of current sensors of the battery being inferior to the number of electric cells of the battery, the first control circuit (BMS) being adapted to receive a new set point (C) for the delivery of a voltage, of a current, and/or of a number of electric cells to be connected between the first and second terminals (Phase, Neutral) and to transmit to the second control circuits (12), control signals for the connection or the disconnection of at least one of the electric cells (C₁, C₂, C₃, C₄) of the modules (Eᵢ) to follow said set point (C),
the battery being **characterized in that** the first control circuit being capable of updating a first counter representative of the quantity of charges flowing through the first terminal based on the sensor measurements and, for each electric cell, for each connection of the electric cell to the other electric cells, the first control circuit or the second control circuit associated with said electric cell being capable of storing into first data the value of the first counter on connection of the electric cell and for each disconnection of the electric cell from the other electric cells, being capable of storing into a second counter the difference between the value of the first counter on disconnection of the electric cell and the first data of said electric cell.

8. The battery according to claim 7, comprising a single sensor of the current flowing through the electric cells (C₁, C₂, C₃, C₄) .
